# EUROPEAN PATENT APPLICATION

(11) **EP 2 432 032 A2**
(43) Date of publication of application: **21.03.2012**
(21) Application number: 11179151.3
(22) Date of filing: 29.08.2011
(51) Int. Cl.: H01L 31/05

(54) **Solar cell module and laminating method**

(30) Priority: 15.09.2010 JP 2010207307
(71) Applicant: Fuji Electric Co., Ltd., Kawasaki-shi 210-9530 (JP)
(72) Inventor: Tanda, Masayuki, Kawasaki-shi, 210-9530 (JP)
(74) Representative: MERH-IP Matias Erny Reichl Hoffmann

(57) **Abstract**

Disclosed is a technique capable of connecting internal wiring lines to a plurality of sheet-shaped photoelectric conversion elements without damaging flexibility. Sub-metal foil lines are arranged so as to come into contact with rear electrode layers of photoelectric conversion elements. The sub-metal foil line is fixed to the rear electrode layer by an adhesive tape. In addition, the sub-metal foil line is folded such that a main metal foil line is interposed between the folded portions of the sub-metal foil line. In this way, the main metal foil line is connected to the sub-metal foil line. The sub-metal foil line is fixed to the rear electrode layer by an adhesive tape.

## Description

### BACKGROUND OF THE INVENTION

### 1. Field of the Invention

The present invention relates to a solar cell module and a laminating method, and more particularly, to a method of forming wiring lines of a solar cell module.

### 2. Description of the Related Art

When solar cells are installed on the roof and then used, amorphous silicon solar cells are promising in terms of productivity or costs.
In the amorphous silicon solar cell, a flexible module has been developed in which photoelectric conversion elements are formed on a film substrate and the surfaces of the photoelectric conversion elements are covered with a protective film and an adhesive sheet.
Internal wiring lines including a main wiring line and a sub-wiring line are used in order to extract power from the solar cell module covered with the protective film to the outside. The photoelectric conversion element in the solar cell module is connected to the sub-wiring line and the sub-wiring line is connected to the main wiring line. Portions of the protective film and the adhesive sheet arranged on the end of the main wiring line are removed such that the end of the main wiring line is exposed. The end of an external lead is soldered to the exposed portion (see Japanese Patent Application Laid-Open No. 10-173209).

However, when the number of sub-wiring lines increases, it is difficult to connect the sub-wiring lines to the main wiring line without any distortion. When the shape of the internal wiring line of the solar cell module is determined by the connection of the sub-wiring line to the main wiring line, there remains as distortion the difference between the shape of the internal wiring line and the deformation of the photoelectric conversion element or the protective film that mainly occurs due to heating in the subsequent module manufacturing process. As a result, the flexibility of the solar cell module is damaged.
In addition, in the process of removing the portions of the protective film and the adhesive sheet arranged on the end of the main wiring line such that the end of the main wiring line is exposed, there is a problem in that the adhesive sheet is not completely removed and an insulator remains on the surface of the main wiring line, or the main wiring line is damaged during removal. In addition, in order to solve the problem, it takes a long time to remove the adhesive sheet.

### SUMMARY OF THE INVENTION

An object of the invention is to provide a solar cell module and a laminating method capable of connecting an internal wiring line to a photoelectric conversion element without damaging flexibility and facilitating the connection of an external wiring line to the internal wiring line.

In order to achieve the object, according to a first aspect of the invention, there is provided a solar cell module including: a plurality of sheet-shaped photoelectric conversion elements; sub-metal foil lines that are provided so as to come into contact with electrodes of the plurality of photoelectric conversion elements; a main metal foil line that is connected to the sub-metal foil line which is folded such that the main metal foil line is interposed between the folded portions and extracts power generated from the plurality of photoelectric conversion elements to the outside; and protective films and adhesive sheets that are provided so as to cover both surfaces of each of the plurality of photoelectric conversion elements together with the main metal foil line and the sub-metal foil lines.
According to this structure, flexibility in the connection between the main metal foil line and the sub-metal foil line forming the internal wiring lines of the solar cell module is obtained and it is possible to absorb distortion occurring in the manufacture of the solar cell module. Therefore, it is possible to connect the internal wiring lines to a plurality of photoelectric conversion elements without damaging the flexibility of the module.

According to a second aspect of the invention, in the solar cell module according to the first aspect, the length of the folded portion of the sub-metal foil line may be equal to or more than the width of the main metal foil line.
According to this structure, the main metal foil line is reliably interposed between the folded portions of the sub-metal foil line and it is possible to reliably connect the main metal foil line and the sub-metal foil line.
According to a third aspect of the invention, in the solar cell module according to the second aspect, the folded portion of the sub-metal foil line may be fixed to the electrode by an adhesive tape. According to this structure, it is possible to reliably fix the sub-metal foil line to the electrode and prevent the main metal foil line from being taken off from the interposed portion.
According to a fourth aspect of the invention, in the solar cell module according to the third aspect, only a part of the folded portion of the sub-metal foil line that does not overlap the main metal foil line may be fixed to the electrode by the adhesive tape. According to this structure, it is possible to reliably ensure flexibility in the positional relationship between the main metal foil line and the sub-metal foil line.

According to a fifth aspect of the invention, there is provided a laminating method including: arranging sub-metal foil lines so as to come into contact with electrodes of a plurality of sheet-shaped photoelectric conversion elements; folding the sub-metal foil line such that a main metal foil line which extracts power generated from the plurality of photoelectric conversion elements to the outside is interposed between the folded portions, thereby connecting the main metal foil line to the sub-metal foil line; and sequentially laminating a first protective film, a first adhesive sheet, the photoelectric conversion elements including the sub-metal foil lines and the main metal foil line provided therein, a second adhesive sheet, and a second protective film, and performing a heat treatment to integrate the first protective film, the first adhesive sheet, the photoelectric conversion elements, the second adhesive sheet, and the second protective film.
According to this structure, it is possible to manufacture a structure in which a module including a plurality of sheet-shaped photoelectric conversion elements connected to each other by a main metal foil line and sub-metal foil lines is covered with a protective film, without damaging flexibility.

According to a sixth aspect of the invention, there is provided a laminating method including: arranging sub-metal foil lines so as to come into contact with electrodes of a plurality of sheet-shaped photoelectric conversion elements; folding the sub-metal foil line such that a main metal foil line which extracts power generated from the plurality of photoelectric conversion elements to the outside is interposed between the folded portions, thereby connecting the main metal foil line to the sub-metal foil line; sequentially laminating a first protective film, a first adhesive sheet, the photoelectric conversion elements including the sub-metal foil lines and the main metal foil line whose end is folded provided therein, a second adhesive sheet, and a second protective film, and performing a heat treatment to integrate the first protective film, the first adhesive sheet, the photoelectric conversion elements, the second adhesive sheet, and the second protective film; and trimming the first protective film, the first adhesive film, the second protective film, and the second adhesive film together with the folded portion of the end of the main metal foil line. According to this structure, an external lead can be inserted into a gap formed by trimming the folded portion of the main metal foil line. Therefore, it is possible to extract power generated from a plurality of photoelectric conversion elements to the outside and easily connect the external lead and the main metal foil line.

According to a seventh aspect of the invention, the laminating method according to the sixth aspect may further include: removing the folded portion of the end of the main metal foil line together with the first protective film and the first adhesive sheet, or the second protective film and the second adhesive sheet.
According to this structure, it is possible to easily expose the main metal foil line without an insulator remaining on the surface of the main metal foil line.

As described above, according to the above-mentioned aspects of the invention, when a metal foil line is connected to a plurality of sheet-shaped photoelectric conversion elements covered with a protective film to extract power to the outside, it is possible to give flexibility to the arrangement of the metal foil line. Therefore, it is possible to connect internal wiring lines to a plurality of photoelectric conversion elements without damaging the flexibility of the solar cell module.

### BRIEF DESCRIPTION OF THE DRAWINGS

Fig. 1A is a perspective view schematically illustrating the structure of a solar cell module according to an embodiment of the invention;
Fig. 1B is a cross-sectional view schematically illustrating the structure of the solar cell module taken along the line A-A' of Fig. 1A;
Fig. 1C is an enlarged perspective view illustrating a photoelectric conversion element 3 shown in Fig. 1B;
Fig. 2 is a plan view illustrating a method of connecting wiring lines of a solar cell module according to an embodiment of the invention;
Figs. 3A to 3C are plan views illustrating a method of connecting a sub-metal foil line 33 and a main metal foil line 34 of a solar cell module according to an embodiment of the invention; and
Figs. 4A to 4E are plan views and a perspective view illustrating a method of connecting the main metal foil line 34 of a solar cell module according to an embodiment of the invention to the outside.

### DETAILED DESCRIPTION OF THE PREFERRED EMBODIMENTS

Hereinafter, a solar cell module according to an embodiment of the invention will be described with reference to the accompanying drawings.

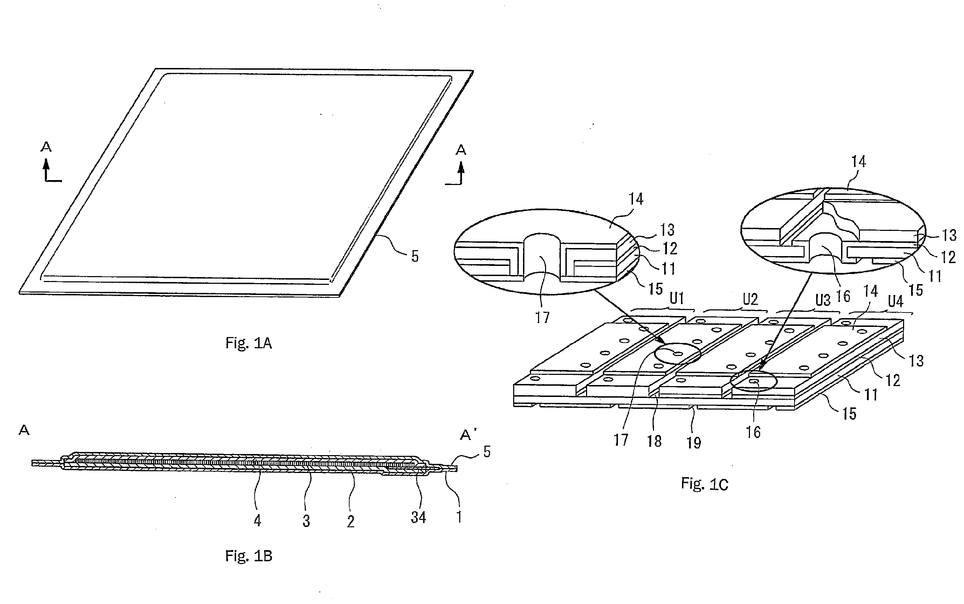

Figs. 1A to 1C are perspective views and a cross-sectional view schematically illustrating the structure of a solar cell module according to an embodiment of the invention.
In Figs. 1A and 1B, a plurality of photoelectric
conversion elements 3 is bonded to a protective film 1 with an adhesive sheet 2 interposed therebetween and a protective film 5 is bonded to the photoelectric conversion elements 3 with an adhesive sheet 4 interposed therebetween. In addition, a main metal foil line 34 that extracts power from the photoelectric conversion elements 3 to the outside is arranged on the electrodes of the photoelectric conversion elements 3.

In Fig. 1C, a photoelectric conversion layer 13 is deposited on a film substrate 11 with a back electrode layer 12 interposed therebetween and a transparent electrode layer 14 is deposited on the photoelectric conversion layer 13. In addition, a rear electrode layer 15 is formed on the rear surface of the film substrate 11. For example, a polyimide or polyamide resin film may be used as the film substrate 11, a pin structure made of amorphous silicon may be used as the photoelectric conversion layer 13, and an ITO film may be used as the transparent electrode layer 14.

Grooves 19 are formed in the rear electrode layer 15 to divide the rear electrode layer 15. Grooves 18 that divide the back electrode layer 12, the photoelectric conversion layer 13, and the transparent electrode layer 14 are formed in the back electrode layer 12, the photoelectric conversion layer 13, and the transparent electrode layer 14 such that they are in parallel to each other and alternate with the grooves 19. In this way, unit cells U1 to U4 are formed. In the film substrate 11, series holes 16 that connect the divided photoelectric conversion layers 13 in series to each other are formed in each of the unit cells U1 to U4. The rear electrode layer 15 and the back electrode layer 12 that are opposite to each other with the film substrate 11 interposed therebetween are connected to each other by the series holes 16.

Power collection holes 17 that collect charge generated from the photoelectric conversion layers 13 to the rear electrode layer 15 are formed in the film substrate 11, the back electrode layer 12, and the rear electrode layer 15 for each of the unit cells U1 to U4. The transparent electrode layer 14 is connected to the rear electrode layer 15 through the power collection holes 17.
The series holes 16 and the power collection holes 17 are arranged such that the series holes 16 in each of the unit cells U1 to U4 are connected to the rear electrode layer 15 that is provided immediately below the series holes 16 and the power collection holes 17 in each of the unit cells U1 to U4 are connected to the rear electrode layer 15 that is adjacent to the rear electrode layer 15 connected to the series holes 16.

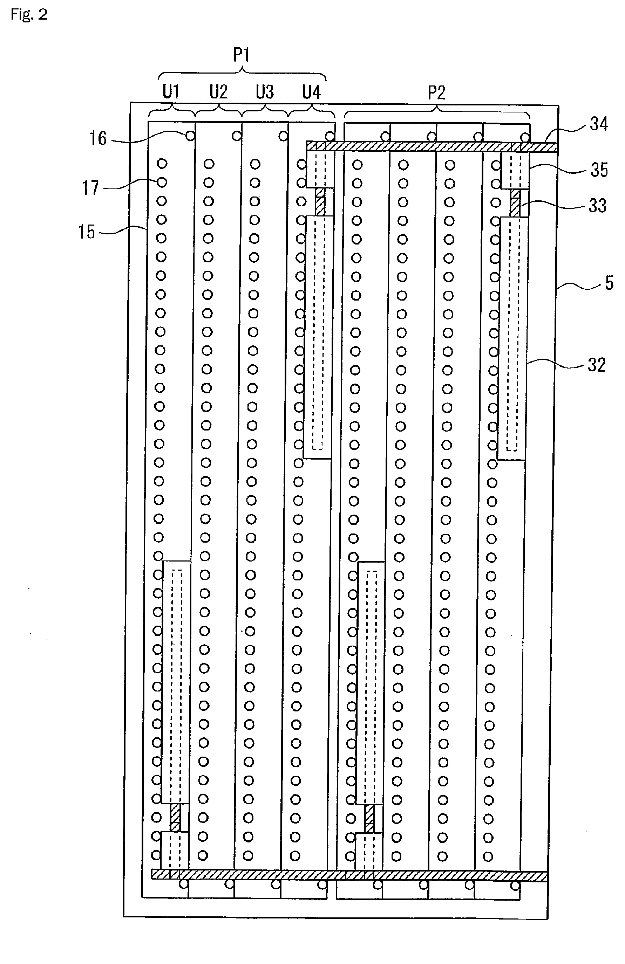

As shown in Fig. 2, sub-metal foil lines 33 are arranged so as to come into contact with the rear electrode layers 15 of photoelectric conversion elements P1 and P2. The sub-metal foil line 33 is fixed to the rear electrode layer 15 by an adhesive tape 32. The sub-metal foil line 33 is folded such that the main metal foil line 34 is interposed between the folded portions. In this way, the main metal foil line 34 is connected to the sub-metal foil line 33. The main metal foil line 34 extends to the end of the protective film 5. For example, solder-coated copper foil lines may be used as the sub-metal foil line 33 and the main metal foil line 34. When the main metal foil line 34 traverses the rear electrode layers 15 of different unit cells U1 to U4, an insulating sheet may be provided below the main metal foil line 34 in the unit cells U1 to U4, or the main metal foil line 34 may be covered with an insulator, thereby ensuring the insulation between different unit cells U1 to U4.
In this way, flexibility in the connection between the main metal foil line and the sub-metal foil line forming the internal wiring lines of the solar cell module is obtained and it is possible to absorb distortion occurring in the manufacture of the solar cell module. Therefore, it is possible to connect the internal wiring lines to a plurality of photoelectric conversion elements P1 and P2 without damaging the flexibility of the module.

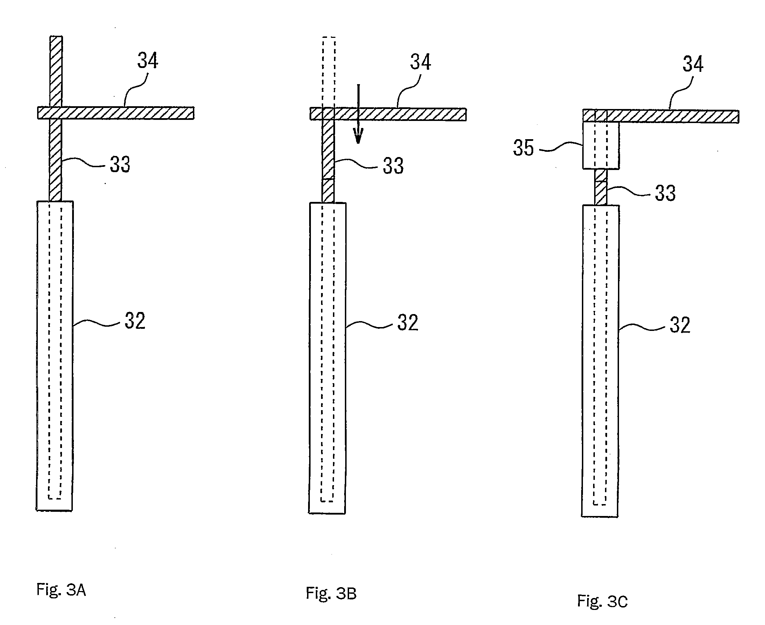

Figs. 3A to 3C are plan views illustrating a method of connecting the sub-metal foil line 33 and the main metal foil line 34 of the solar cell module according to the embodiment of the invention.
In Fig. 3A, the main metal foil line 34 is superimposed on the sub-metal foil line 33 such that the main metal foil line 34 is orthogonal to the sub-metal foil line 33. Then, as shown in Fig. 3B, the sub-metal foil line 33 is folded such that the folded portions of the sub-metal foil line 33 overlap each other with the main metal foil line 34 interposed therebetween. That is, the main metal foil line 34 is interposed between the folded portions of the sub-metal foil line 33 in the vertical direction. When the length of the folded portion of the sub-metal foil line 33 is equal to or more than the width of the main metal foil line 34, the main metal foil line 34 is reliably interposed between the folded portions. When the length of the folded portion is 4 to 5 times more than the width of the main metal foil line 34, the main metal foil line 34 is more reliably interposed between the folded portions and it is possible to prevent the main metal foil line 34 from being fixed by the adhesive tape 35 due to an error. Then, as shown in Fig. 3C, the folded portion of the sub-metal foil line 33 is fixed to the rear electrode layer 15 by the adhesive tape 35. In this way, it is possible to prevent the main metal foil line 34 from being taken off from the folded portions of the sub-metal foil line 33. For example, when a metal foil label with a conductive adhesive is used as the adhesive tapes 32 and 35, it is possible to reliably connect the sub-metal foil line 33 and the rear electrode layer 15.

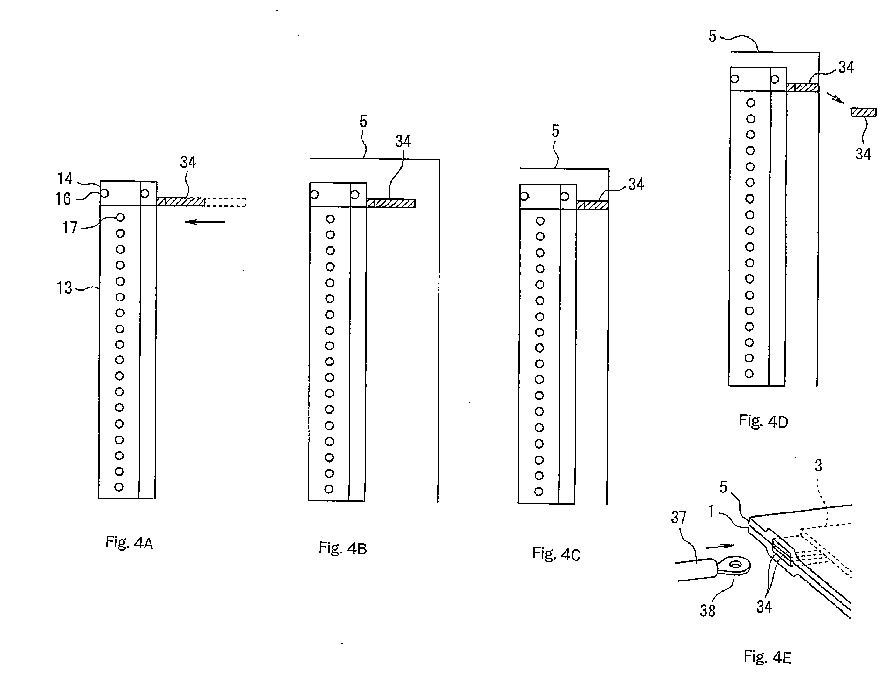

Figs. 4A to 4E are plan views and a perspective view illustrating a method of connecting the main metal foil line 34 of the solar cell module according to the embodiment of the invention to the outside.
In Fig. 4A, the main metal foil line 34 is placed so as to extend to the outside of the photoelectric conversion element 3 shown in Figs. 1A to 1C, and the end of the main metal foil line 34 is folded such that the ends of the main metal foil line 34 overlap each other. Then, as shown in Fig. 4B, the protective films 1 and 5 are placed on the photoelectric conversion element 3 and the main metal foil line 34 to seal the photoelectric conversion element 3 and the main metal foil line 34. Then, as shown in Fig. 4C, the protective films 1 and 5 are trimmed together with the end of the folded portion of the main metal foil line 34. Then, when the end of the folded portion of the main metal foil line 34 is removed together with the protective film 1 or 5 as shown in Fig. 4D, it is possible to easily expose the surface of the main metal foil line 34 to the outside. In addition, as shown in Fig. 4E, for example, a crimp-type terminal 38 provided at an external lead 37 may be inserted into the gap between two folded main metal foil lines 34 without performing the process shown in Fig. 4D. In this case, it is also possible to connect the external lead line 37 and the main metal foil line 34.

## Claims

1. A solar cell module comprising:
a plurality of sheet-shaped photoelectric conversion elements (3);
sub-metal foil lines (33) that are provided so as to come into contact with electrodes (15) of the plurality of photoelectric conversion elements (3);
a main metal foil line (34) that is connected to the sub-metal foil line (33) which is folded such that the main metal foil line (34) is interposed between the folded portions and extracts power generated from the plurality of photoelectric conversion elements (3) to the outside; and
protective films (5) that are provided so as to cover both surfaces of each of the plurality of photoelectric conversion elements (3) together with the main metal foil line (34) and the sub-metal foil lines (33).

2. The solar cell module according to claim 1,
wherein the length of the folded portion of the sub-metal foil line (33) is equal to or more than the width of the main metal foil line (34).

3. The solar cell module according to claim 1 or 2,
wherein the folded portion of the sub-metal foil line (33) is fixed to the electrode (15) by an adhesive tape (35).

4. The solar cell module according to claim 3,
wherein only a part of the folded portion of the sub-metal foil line (33) that does not overlap the main metal foil line (34) is fixed to the electrode by the adhesive tape (35).

5. A laminating method comprising:
arranging sub-metal foil lines (33) so as to come into contact with electrodes (15) of a plurality of sheet-shaped photoelectric conversion elements (3);
folding the sub-metal foil line (33) such that a main metal foil line (34) which extracts power generated from the plurality of photoelectric conversion elements (3) to the outside is interposed between the folded portions, thereby connecting the main metal foil line (34) to the sub-metal foil line (33); and
sequentially laminating a first protective film (5), a first adhesive sheet, the photoelectric conversion elements (3) including the sub-metal foil lines (33) and the main metal foil line (34) provided therein, a second adhesive sheet, and a second protective film (5), and performing a heat treatment to integrate the first protective film, the first adhesive sheet, the photoelectric conversion elements, the second adhesive sheet, and the second protective film.

6. A laminating method comprising:
arranging sub-metal foil lines (33) so as to come into contact with electrodes (15) of a plurality of sheet-shaped photoelectric conversion elements (3);
folding the sub-metal foil line (33) such that a main metal foil line (34) which extracts power generated from the plurality of photoelectric conversion elements (3) to the outside is interposed between the folded portions, thereby connecting the main metal foil line (34) to the sub-metal foil line (33);
sequentially laminating a first protective film (5), a first adhesive sheet, the photoelectric conversion elements (3) including the sub-metal foil lines (33) and the main metal foil line (34) whose end is folded provided therein, a second adhesive sheet, and a second protective film (5), and performing a heat treatment to integrate the first protective film, the first adhesive sheet, the photoelectric conversion elements, the second adhesive sheet, and the second protective film; and
trimming the first protective film and the second protective film together with the folded portion of the end of the main metal foil line.

7. The laminating method according to claim 5, further comprising
trimming the first protective film and the second protective film together with the folded portion of the end of the main metal foil line.

8. The laminating method according to claim 6 or 7, further comprising:
removing the folded portion of the end of the main metal foil line (34) together with the first protective film (5) and the first adhesive sheet, or the second protective film (5) and the second adhesive sheet.
